# EUROPÄISCHE PATENTSCHRIFT

(11) **EP 3 262 673 B1**
(45) Veröffentlichungstag und Bekanntmachung des Hinweises auf die Patenterteilung: **16.09.2026**
(21) Anmeldenummer: 16715440.0
(22) Anmeldetag: 26.02.2016
(51) Int. Cl.: H01L 21/20, H01G 9/20, H01L 31/0392, H01L 31/046, H01L 31/0463, H10K 71/40

(54) **RAUMTEMPERATUR-VERFAHREN ZUR HERSTELLUNG EINER PV-SCHICHTFOLGE**
ROOM TEMPERATURE METHOD FOR PRODUCING A PV FILM STRUCTURE
PROCÉDÉ À TEMPÉRATURE AMBIANTE POUR FABRIQUER UNE SUCCESSION DE COUCHES PV

(30) Priorität: 26.02.2015 DE 102015102801; 02.12.2015 DE 102015015435; 06.12.2015 DE 102015015600
(43) Veröffentlichungstag der Anmeldung: 03.01.2018
(73) Patentinhaber: Holyvolt AB, 114 27 Stockholm (SE)
(72) Erfinder: LINDER, Patrick, 91611 Lehrberg (DE); LINDER, Daniel, 91611 Lehrberg (DE)
(74) Vertreter: Ström & Gulliksson AB
(86) Internationale Anmeldenummer: PCT/DE2016/100084
(87) Internationale Veröffentlichungsnummer: WO 2016/134704

(56) Entgegenhaltungen:
- DE-A1- 102007 014 608
- DE-A1- 102012 107 100

## Beschreibung

### TECHNISCHER BEREICH

Die vorliegende Erfindung kann allgemein im Bereich elektrotechnischer Dünnschichten angeordnet werden. Bekannte Maßnahmen, Merkmale und Methoden können in diesem Bereich gefunden werden.

### BESCHREIBUNG DES STANDES DER TECHNIK

Die vorliegende Erfindung betrifft ein Raumtemperatur-Verfahren zur Herstellung einer PV-Schichtfolge gemäß des Oberbegriffs des unabhängigen Anspruches.

Gewerblich betrachtet ist ein wesentlicher Aspekt, dass die Herstellung bei Raumtemperatur erfolgt. Dies senkt verfahrenstechnisch die Kosten der Herstellung erheblich und bietet einen substantiellen Vorteil in der Produktion. Es bedeutet aber auch, dass in der PV-Schichtfolge keine bei erhöhter Temperatur präzise versinterten oder gezielt kompaktierten Schichten gegeben sein können. Die gezielt eingestellte, nanoskalige Planarität eines photovoltaisch aktiven Schichtverbundes ist aber ein leistungswesentliches Merkmal der etablierten PV-Systeme: PV-Schichten werden hier regelmäßig mittels Vakkum-Plasma-Verfahren präzise eingestellt, um eine ausreichende Energieausbeute sicherstellen zu können. Raumtemperatur-Verfahren, welche Dünnschichten - also feste, durchgehende Schichtfolgen - durch Drucken, Schleudern oder Fluten - also durch mechanische Maßnahmen - erzeugen, können Planaritäten im Nanometerbereich aber regelmäßig nicht kontrolliert einstellen. Die Schichten sind uneben und häufig nur im Mikrometerbereich plan. Unebene Schichten, die nur im Mikrometerbereich plan sind, können einen nanoskalig per Dotierung eingestellten, flächigen PV-Übergang nachteilig nur unter erheblichen Verlusten zur Stromerzeugung verwenden. Darauf führen die Erfinder zurück, dass sich im Bereich der photovoltaischen, kommerziellen Produktions-Technik nur wenige Dokumente und Ansätze mit RT-Herstellungsverfahren (RT = Raumtemperatur) ernsthaft befassen: Die JP H4-249379 A beschreibt eine PV-Vorrichtung und ein Verfahren zu dessen Herstellung, wobei per CVD-Verfahren (CVD = chemische Gasphasen-Abscheidung, d. h. die Gasphase dient begleitend zum Erzwingen einer chemischen Reaktion) unter Unterdruck verschieden Reaktionen umfassend Abscheidungs- und Ätzprozesse vorgenommen werden, um so zunächst die hoch planare, flächige PV-Grundstruktur auszubilden. Nachteilig macht hierbei die Vakuum-Reaktionskammer eine teure Batch-Verarbeitung notwendig: In eine Vakuum-Reaktionskammer können immer nur eine bestimmte Anzahl Substrate eingeschleust, anschließend evakuiert und ggf. getrocknet und abschließend nach Beschichtung unter Reaktiv-Gas-Atmosphäre wieder entnommen werden. Zudem sind die zu beschichtenden Substrate nachteilig während des Beschichtens auf präzise eingestellten Temperaturen zu halten, damit stets die gleiche Art und Dicke von Schicht reaktiv ausgebildet wird. Weiterhin lehrt dieses Dokument die abschließende Bedruckung mit einer Cu-Elektrodenpaste, welche eingebrannt werden muss, d. h. der Schichtverbund muss im Rahmen der Kontaktierung hohen Temperaturen ausgesetzt werden, wobei sowohl die Schichten der PV-aktiven Schicht als auch die Schichten, welche die Elektroden ausbilden sollen, zu einer elektrisch ausreichend leitfähigen und kontaktierten Gesamtzelle kompaktiert und versintert werden. Gerade der nachteilige, thermische Kompaktierungs-Schritt bedeutet hohe Kosten und Nachteile, weil Unreinheiten und kleinste Verunreinigungen bei Sintertemperaturen, welche KupferPasten zu einer Leiterbahn versintern, ebenso der Diffusion unterliegen. Deshalb müssen für solche Herstellungsmethoden teure, hoch reine Edukte verwendet werden, welche auch bei abschließendem Sinterschritt keine Unreinheiten aufweisen, denn die Unreinheiten würden sonst abschließend in die PV-aktive Schicht eindiffundieren und diese schwächen oder gar komplett zerstören.

Gleichsinnig schlägt die CA 2 467 690 A eine druckbare Heißkleber-Mischung vor, welche als Elektrodenstruktur und/oder Kontakt auf elektrotechnische Dünnschichtfolgen, insbesondere PV-Schichtfolgen, aufgebracht werden kann. Die Leitfähigkeits-Paste enthält leitfähige Blei-Glaspartikel, auf deren Oberfläche Silber- oder Aluminium-Flakes aufziehen; diese Grundmischung wird mit einer thermoplastischen Matrix fixiert. Nachteilig müssen aber auch hier sämtliche organischen Anteile bei 650 °C bis 900 °C abschließend ausgebrannt werden, weil sonst keine ausreichende Leitfähigkeit und auch keine Stabilität der Schicht gewährleistet ist.

Die CN 10 329 3600 A offenbart in ihrem Abstract ein Verfahren zur Ausbildung von 5 optischen Schichten, welche Licht gezielt ein- oder ausleiten und sich für PV- oder Display-Vorrichtungen eignen. Hierbei wird auf eine Polyimid-Schicht ein Polymer in gewünschter Anordnung und Raumform aufgedruckt und abschließend auf Polymerisationstemperatur aufgeheizt. Durch gezielte Anordnung und Modifikation von Molekülketten kann dabei der Brechungsindex der optischen Schicht richtungsabhängig eingestellt werden, sodass die optische Deckschicht nicht mehr abschließend geätzt oder strukturiert werden muss. Nachteilig ist auch hier ein abschließendes Aufheizen vorgesehen, um eine vollständige Polymerisation sicherzustellen. Weiterhin bietet dieses Dokument kein Anhaltspunkte, ob und wie solche Methoden auf einen kompletten PV-Schichtverbund, insbesondere auf eine PV-aktive Schicht oder Schichtkombination angewendet werden könnten.

Gleichsinnig offenbart die TW 2014 42 271 A in ihrem Abstract ein Versiegelungssystem für PV-Module, bei dem ein fertiges PV-ModuI auf einem Substrat vorgelegt und über eine Ink-Jet-Druckstation mit UV-härtendem Klebstoff in verschiedenen Farben bei Raumtemperatur ummantelt und gleichzeitig in festem Verbund mit dem Substrat versiegelt wird. Nachteilig ist auch hier eine übliche, etablierte PV-aktive Schicht als Modul zu verwenden, d. h. ein Herstellungsprozess der Strom liefernden, PV-aktiven Schicht erfolgt auf etablierte und kostspielige Weise mit den bereits dargelegten Nachteilen.

Die CN 10 321 434 0 A offenbart in ihrem Abstract ein Triptycen-System, welches über einen Sol-Gel-Prozess als nanoskalige, wässrige Dispersion vorgelegt werden kann. Die wässrige Dispersion kann 50 Nanometer bis 200 Mikrometer große Agglomerate des Triptycens bereitstellen und damit Halbleitereigenschaften bieten, welche über die wässrige Dispersion in vorgegebene Bereiche druckbar sind.

'Druckbar' umfasst - auch im Sinne der vorliegende Erfindung - übliche Drucksysteme, sprich Air-Brush-Sprühköpfe, Inkjet-Druckköpfe, elektrostatische Aufsprühung von Farben oder Farbpigmenten, Tampon-Druck, Lithographie-Druck, Flexo-Druck, Offset-Druck bis hin zu Thermosublimations-Druck welcher Pigment-Farben über eine aufschmelzbare Thermoplast-Basis aufzubringen vermag. Nachteilig umfasst Triptycen Benzol-Gruppen; es wird aus Dehydrobenzol und Anthracen gewonnen. Solche Systeme enthalten regelmäßig Nebenprodukte, welche mit der Zeit aus der Matrix des Hauptproduktes langsam ausgasen. Mithin sind solche organischen, elektrotechnischen Dünnschichten regelmäßig nicht Langzeitstabil, zeigen im Korrosionsverhalten eine starke, anfängliche Verschlechterung der elektrotechnischen Eigenschaften und enthalten deklarationspflichtige Komponenten wie Benzol, welche als volatile, organische Komponenten, häufig abgekürzt als VOC, aus dem Schichtverbund ausgasen, Anwesende gefährden und angrenzende Schichten zusätzlich beeinträchtigen oder gar zerstören können.

Die CN 103 839 605 A offenbart in ihrem Abstract eine Leitfähigkeits-Dispersion auf Silber-Graphen-Basis, wobei diese Basis in einem organischen Harz mit Quervernetzern und Verdünnern dispergiert und so als druckbare, organische Paste bereitgestellt wird. Nachteilig sind Harze nur grob auf eine mittlere Molmasse eingestellt; sie umfassen regelmäßig VOC-Anteile und häufig potentiell krebserregende Benzole und deren Derivate. Zudem sind Klebstoffe, welche Verdünner enthalten, Dispersionsklebstoffe: Sie härten unter Verdunstung des Verdünners / Lösungsmittels, was bei Raumtemperatur nicht schnell und vollständig gelingen kann und somit langfristig ein kontinuierliches Ausdunsten des Verdünners bedeutet. Unvollständige Aushärtung und die Gefahr einer langfristigen VOC-Freisetzung sind für solche Harzsysteme bekannte und typische Nachteile.

Aus der DE 10 2012 107 100 A1 ist das Auftragen von Pasten per Siebdruck bekannt. Nachteilig müssen diese Pasten bei wenigen Hundert Grad Celsius durch Sintern in eine durchgängige Volumenschicht umgewandelt werden. Organische Anteile sind zudem durch längeres Erhitzen zu zerstören, um die anorganischen, durchgehenden Schichten überhaupt erst erhalten zu können.

Aus der DE 10 2007 014 608 A1 ist ein halbleitender Film bekannt, welcher in der Herstellung thermisch behandelt wird. In einem Verfahrensschritt werden die Partikel zumindest teilweise versintert. Gleichsinnig zu etablierten Verfahren wird auch hier ein klassischer Hochtemperaturofen durch eine alternative und weniger voluminöse Energiequelle ersetzt (bevorzugt: Laserpulse gemäß Absatz 50). Ein Versintern ist dabei aber stets vorgesehen, auch wenn die Poren dabei größer bleiben könnten. Mithin benötigt auch dieses Verfahren nachteilig die für Sinterprozesse notwendigen Energiemengen, Anlagen und Schutzvorrichtungen.

Aufgabe der vorliegenden Erfindung war es daher, die Nachteile des Standes der Technik zu überwinden und ein Verfahren bereitzustellen, welches trotz industrieller Prozessführung bei Raumtemperatur und großflächiger Fabrikation Dünnschichten bieten kann, die eine PV-aktive Schicht in einem fertigen, kontaktierbaren Schichtverbund bereitstellen.

Die Lösung dieser Aufgabe erfolgt gemäß der Merkmale des unabhängigen Anspruchs. Vorteilhafte Ausführungsformen ergeben sich aus der nachfolgenden Beschreibung.

### ZUSAMMENFASSUNG DER ERFINDUNG

Erfindungsgemäß wird eine PV-Schichtfolge durch ein Raumtemperatur-Verfahren gemäß Anspruch 1 erhalten; das umfasst, dass die PV-Schichtfolge als Dünnschichtfolge zumindest inklusive Kontaktelektroden bei Raumtemperatur in kontinuierlichem Druckprozess gedruckt, mindestens eine wässrige Lösung und / oder Mischung umfassend elektrisch leitende und/oder halbleitende, anorganische Agglomerate aufgedruckt und unter begleitender, chemischer Reaktion zu einer PV-aktiven Schicht ausgehärtet worden ist, wobei wiederum während der Reaktion nanoskalige Strukturen umfassend mindestens eine Struktur ausgewählt aus der Gruppe bestehend aus Ketten, Netzen, Netz-Röhren, Leerstellen, Poren in der PV-Schichtfolge ausgebildet wurden.

Das Raumtemperatur-Verfahren zur Herstellung elektrotechnischer PV-Dünnschichten, bei dem elektrisch leitende und/oder halbleitende, anorganische Agglomerate in einer Dispersion flächig vorgelegt und zu einer Schicht ausgehärtet werden, umfasst somit, dass die Aushärtung bei Raumtemperatur durchgeführt wird und die Aushärtung durch Beaufschlagen mit mindestens einem Reagenz beschleunigt wird, wobei eine PV-Schichtfolge ausgebildet wird.

### BESCHREIBUNG DER ERFINDUNG UND VORTEILHAFTER MERKMALE

Eine PV-Schichtfolge ist über das vorliegend beanspruchte Verfahren zugänglich.

Die erfindungsgemäße PV-Schichtfolge wird erhalten durch ein Raumtemperatur-Verfahren. 'Raumtemperatur' liegt im für Menschen akzeptablen und üblichen Bereich und liegt im europäischen Bereich um 25 Grad Celsius +- 5 Grad Celsius. Bei dieser Temperatur wird die PV-Schichtfolge als Dünnschichtfolge ausgebildet.

'Dünnschicht' umfasst im Sinne der vorliegenden Erfindung Schichten im Mikrometerbereich, deren Schichtdicken sinnvoll mit Mikrometern angegeben werden können und nicht mehr als zwei Größenordnungen abweichen. Die PV-Schichtfolge wird zumindest inklusive Kontaktelektroden bei Raumtemperatur in kontinuierlichem Druckprozess gedruckt. Dadurch entsteht eine fertige PV-Schichtfolge, welche nur noch an ein bestehendes System angeschlossen werden muss, um photovoltaischen Strom abnehmen und verwerten zu können.

Im Rahmen des Herstellungsverfahrens wird mindestens eine wässrige Lösung und / oder Mischung umfassend elektrisch leitende und/oder halbleitende, anorganische Agglomerate aufgedruckt und unter begleitender, chemischer Reaktion zu einer PV-aktiven Schicht ausgehärtet. Durch das Drucken einer reaktiven Lösung oder Mischung wird die Aushärtezeit extrem verkürzt und es werden erstmals Produktionszeiten zugänglich, wie sie aus dem industriellen Druckbereich bekannt sind. Weiterhin gehen die Erfinder davon aus, dass die Aushärtung typischer Weise an der Oberfläche einer Dünnschicht am schnellsten abläuft und dadurch in der Dünnschicht selbst einen Gradienten aufbaut, welcher die elektrotechnischen Eigenschaften sinnvoll zu erklären vermag: Ein Gradient an Leerstellen und/oder Reaktionsprodukten kann bei leitenden und/oder halbleitenden Agglomeraten eine elektrochemische Triebkraft bewirken, was sinnvoll zu erklären vermag, dass so hergestellte Schichten Ladungen verbessert separieren, PV-Effekte an P-N-Übergängen unterstützen und auch diodenartige Eigenschaften aufweisen können. Ergänzend sind dabei in der PVDünnschicht während der Reaktion nanoskalige Strukturen umfassend mindestens eine Struktur ausgewählt aus der Gruppe bestehend aus Ketten, Netzen, Netz-Röhren, Leerstellen, Poren in der PV-Schichtfolge ausgebildet worden. Besonders vorteilhaft wird dabei sowohl eine reaktiv unterstützte Aushärtung als auch eine Reaktion, welche nanoskalige Strukturen ausbildet, gleichzeitig durchgeführt. Dadurch können sowohl nanoskalige Struktur-Gradienten als auch Konzentrationsgradienten und Größenverteilungen für Nano-Strukturelemente eingestellt werden, worauf die Erfinder zurückführen, dass die messbaren, elektrotechnischen Eigenschaften mehrere Anregungsprozesse innerhalb einer Bandlücke indizieren. Durch die niedrige Herstellungstemperatur wird dabei ein zusätzlicher Vorteil zugänglich: Selbst bei nur technisch reinen Edukten (Reinheiten von 95% bis 99%, bevorzugt 99% +- 0,5%, bei industrieller Großfertigung) können funktionierende, stabile PV-Schichtfolgen erhalten werden, da die im Rahmen der Herstellung gedruckten und/oder chemisch erzeugten P-N-Übergänge nicht durch anschließende Sinterung durch diffundierende Unreinheiten zerstört werden. Weiterhin vermag die anorganische Grundstruktur der Agglomerate, welche die Schichtfolge im Wesentlichen ausbilden, die verbesserte Stabilität zu erklären: So erzeugte Schichtfolgen zeigten nach einer abschließenden, leicht sauren Versiegelung bei Temperaturen um 160 Grad Celsius übliche Leistungswerte, welche im Klimakammertest keinerlei anfängliche Degradation zeigte; über 1000 Stunden waren konkrete PV-Schichtfolgen-Muster Leistungsstabil, was die Erfinder auf die stabile, anorganische Agglomerat-Matrix zurückführen. Die so zugänglichen PV-SchichtfoIgen sind daher sowohl in der benötigten Produktions-Anlage als auch im Bezug auf die Kosten der notwendigen Materialien für einen Bruchteil des üblichen Herstellungspreises erhältlich und zeigen im Vergleich eine deutlich bessere Langzeit-Stabilität ohne anfängliche Degradation.

Bevorzugt weist die Dünnschichtfolge mit erfindungsgemäßer PV-Schichtfolge eine PV-aktive Schicht auf, welche im Bereich langwellig zum sichtbaren Spektralbereich, bevorzugt im Spektral bereich größer 1200nm, besonders bevorzugt im Bereich von 1500 nm bis 4000 nm, mindestens 4% ihrer Leerlaufspannung, bevorzugt 5% bis 18% ihrer Leerlaufspannung, besonders bevorzugt 10 +- 4 % ihrer Leerlaufspannung, erzeugt. Wird ein P-N-Übergang wie vorbeschrieben unter begleitender Reaktion ausgebildet, so können direkt am Übergang Nanostrukturen zusätzlich die Bandlücke modifizieren. Lange, halbleitende bis leitende Nanostrukturen können dabei als zusätzliche, langwellig eingestellte Quanten-Punkte oder -Töpfe angesehen werden, welche zusätzliche Niveaus innerhalb der Bandlücke erzeugen. Darauf führen die Erfinder zurück, dass es bereits gelungen ist, Dünnschichtfolgen herzustellen, welche nur langwellig zum sichtbaren Lichtspektrum Energie erzeugen.

Bevorzugt ist die Dünnschichtfolge mit PV-Schichtfolge dadurch gekennzeichnet, dass die komplette Dünnschichtfolge frei von volatilen, organischen Komponenten ist, keine toxischen Schwermetalle, bevorzugt kein Selen, Arsen, Blei, Cadmium, Indium, Gallium als Zusatz oder zugesetztes Dotierungsmittel enthält, die PV-Schichtfolge einen terrestrischen Wirkungsgrad von mindestens 10 +- 4 % aufweist und die PV-Schichtfolge auf einen Papier-artigen, flexiblen Träger aufbringbar ist. Volatile, organische Komponenten umfassen Weichmacher, langkettige Alkohole und polyannelierte Kohlenwasserstoffe, welche als langkettige und schwere Moleküle mit der Zeit ausgasen und sowohl die Zelle als auch anwesende Menschen schädigen können. Anorganische Agglomerate sind bevorzugt frei von toxischen Schwermetallen, insbesondere sind Selen, Arsen, Blei, Cadmium, Indium, Gallium nicht als Zusatz oder zugesetztes Dotierungsmittel enthalten.

Die so zugänglichen, besonders vorteilhaften PV-Schichtfolgen konnten in konkreten Mustern einen terrestrischen Wirkungsgrad von mindestens 10 +- 4 % aufweisen. Durch Verwendung von Abmischungen und Aufbringungstechniken wie sie aus dem Printbereich bekannt sind, ist das Aufbringen auf Papier die einfachste und schnellste Möglichkeit, erste Testmuster zu fertigen. Diese Muster zeigten eine sonst nur für Print-Produkte typische Flexibilität und Stabilität. Da solche Printprodukte auch auf Transferfolien und/oder Etikettenfolien druckbar sind und dann erst abschließend auf den eigentlichen Träger aufbringbar sind kann die PV-Schichtfolge gleichsinnig auf einen Papier-artigen, flexiblen Träger aufbringbar ausgebildet werden. Entsprechende, selbstklebende Folien mit elektrotechnischen Dünnschichten wurden bereits hergestellt.

Das erfindungsgemäße Raumtemperatur-Verfahren zur Herstellung elektrotechnischer PV-Dünnschichten gemäß Anspruch 1, bei dem elektrisch leitende und/oder halbleitende, anorganische Agglomerate in einer Dispersion flächig vorgelegt und zu einer Schicht ausgehärtet werden, umfasst, dass die Aushärtung bei Raumtemperatur durchgeführt wird und die Aushärtung durch Beaufschlagen mit mindestens einem Reagenz beschleunigt wird, wobei eine PV-Schichtfolge ausgebildet wird.

Bevorzugt ist das Verfahren dadurch gekennzeichnet, dass eine PV-aktive Schicht auf einer Trägerschicht ausgebildet wird, in dem eine fließfähige Mischung oder Lösung vorgelegt, in dünner Schicht aufgetragen, bevorzugt aufgedruckt, und abschließend unter begleitender Reaktion, unterstützt durch mindestens eine Maßnahme, ausgehärtet wird, die mindestens eine Maßnahme ausgewählt aus der Gruppe bestehend aus UV-Belichtung, Beaufschlagung mit C02, Beaufschlagung mit sauren Gasen, Beaufschlagung mit basischen Gasen, Beaufschlagung mit oxidativen Gasen, Beaufschlagung mit reduzierenden Gasen, Beaufschlagung mit Säurechloriden, Beaufschlagung mit Harnstofflösungen, Beaufschlagung mit Metalloxid-Dispersion, Beaufschlagung mit Metallcarbonylen, Beaufschlagung mit Metall-Komplex-Verbindungen, Beaufschlagung mit Metallverbindungen, Beaufschlagung mit Metallsalzen, Beaufschlagung mit Wasser, Beaufschlagung mit Trockenmittel, Beaufschlagung mit Trockengas, Beaufschlagung mit Inertgas, Beaufschlagung mit Trockenluft.

Bevorzugt ist das Verfahren dadurch gekennzeichnet, dass eine PV-aktive Schicht zumindest teilweise angeordnet ist auf einer Trägerschicht, welche mindestens einen Bereich aufweist, welcher zumindest eine Schicht aufweist ausgewählt ist aus der Gruppe bestehend aus leitfähiger Kupfer-Schicht, leitfähiger Graphit-Agglomerat-Schicht, leitfähiger Silber-Agglomerat-Schicht, leitfähiger Gold-Agglomerat-Schicht, leitfähiger Metalloxid-Agglomerat-Schicht, leitfähige Glas-Agglomerat-Schicht, leitfähige Graphen-Schicht, leitfähige CNT-Schicht, leitfähige SWCNT-Schicht, leitfähige MWCNT-Schicht.

Erfindungsgemäß ist das Verfahren weiterhin dadurch gekennzeichnet, dass das Verfahren in einer Druckmaschine durchgeführt wird.

Erfindungsgemäß ist das Verfahren weiterhin dadurch gekennzeichnet, dass eine PV-aktive Schicht eine anorganische Matrix mit interpenetrierendem, organischem Netzwerk aufweist.

Bevorzugt ist das Verfahren dadurch gekennzeichnet, dass die anorganische Matrix mindestens eine Agglomeratsorte, bevorzugt oxidierte Agglomeratsorte, aufweist, welche ausgewählt ist aus der Gruppe bestehend aus Kieselsäure-Agglomerate, basische Kieseläure-Agglomerate, saure Kieselsäure-Agglomerate, Natrium-Wasserglas-Agglomerate, Kalium-Wasserglas-Agglomerate, Brom-Agglomerate, lod-Agglomerate, Halogen-Agglomerate, Kohlenstoff-Agglomerate, Silicium-Agglomerate, Germanium-Agglomerate, Zinn-Agglomerate, Blei-Agglomerate, Bor-Agglomerate, Aluminium-Agglomerate, Gallium-Agglomerate, Indium-Agglomerate, Phosphor-Agglomerate, Arsen-Agglomerate, Antimon-Agglomerate, Schwefel-Agglomerate, Selen-Agglomerate, Tellur-Agglomerate, Bismut-Agglomerate.

Erfindungsgemäß ist das Verfahren weiterhin dadurch gekennzeichnet, dass eine organische Matrix mindestens eine vernetzte Komponente aufweist, welche ausgewählt ist aus der Gruppe bestehend aus Polyamid-Komponente, Poly-Acrylat-Komponente, Polyol-Komponente, Polyester-Komponente, Poly-Hexosen-Komponente, Poly-Aminosäuren-Komponente, quellfähige Poly-Hexosen-Komponente, Rotalgen-Extrakt, Agar-Agar, Maisstärke, Kartoffelstärke, Stärke, Carrageen, Tragant, quellfähiges Polysaccharid, Gummi Arabicum, Alginate, Pektin, quellfähiges Polypeptid, Gelatine, Carboxymethylcellulose, Hydroxyethylcellulose, Polyacryle, Polycarbonsäuren, Polyether, Polyamide, Polyimide, Silicium-organische Verbindung mit polymerisierbarer Seitengruppe auf Methacrylsäurebasis, Organosiloxan.

Bevorzugt ist das Verfahren dadurch gekennzeichnet, dass als begleitende Reaktion mindestens eine Reaktion durchgeführt wird, welche ausgewählt ist aus der Gruppe bestehend aus Oxidation mit einem Halogen, Oxidation unter UV-Belichtung, Oxidation unter UV-Belichtung mit Wellenlängen kleiner 385 nm, Oxidation unter UV-Belichtung mit einer Deuterium-Lampe, Oxidation unter UV-Belichtung mit einer UV-LED mit 365 nm, Oxidation mit Luftsauerstoff, Oxidation unter UV-Belichtung mit einer Quecksilberdampflampe, Oxidation unter UV-Belichtung mit Wellenlängen um 254 nm, Oxidation unter UV-Belichtung mit Wellenlängen um 185 nm, Vernetzung und Oxidation unter UV-Belichtung, Freisetzung von organischen Säuren unter Kondensation, Freisetzung von organischen Alkoholen unter Kondensation, Freisetzung von Alkoholen unter Oxidbildung.

Bevorzugt ist das Verfahren dadurch gekennzeichnet, dass vor oder während des Aushärtens nanoskalige Poly-Ionen eingebracht werden, wobei die Poly-Ionen mindestens eine Sorte Poly-Ionen umfassen, welche ausgewählt ist aus der Gruppe bestehend aus Polyhalogenidionen, Interhalogenidionen, Poly-Sulfid-Ionen, Poly-Iod-Iodid-Ionen, konjugierte Kohlenstoff-Ionen, Graphen-Ionen, CNT-Ionen.

Bevorzugt ist das Verfahren dadurch gekennzeichnet, dass die Länge der - bevorzugt kettenförmigen - Poly-Ionen auf eine mittlere Kettenlänge eingestellt wird.

Bevorzugt ist das Verfahren dadurch gekennzeichnet, dass eine PV-aktive Schicht zumindest anteilig eine Sorte Trägermoleküle aufweist, das Trägermolekül ausgewählt aus der Gruppe bestehend aus Ionen aufnehmende Gerüstpolymere, Li-Ionen aufnehmende Gerüstpolymere, lonentauscher-Harzen, lonentauscher-Polymeren, ionentauschenden Gläsern, Halogenionen tauschenden Gläsern, Halogen-Ionen tauschenden Silikaten, lodophore. Bevorzugt ist das Verfahren dadurch gekennzeichnet, dass eine PV-aktive Schicht mindestens einen weiteren Sensibilisator umfasst.

Erfindungsgemäß ist das Verfahren weiterhin dadurch gekennzeichnet, dass eine begleitende Reaktion einer auf einer leitfähigen Komponente aufgebrachte, PV-aktive Schicht eine oberflächliche Oxidation einer metallischen Komponente umfasst.

Bevorzugt ist das Verfahren dadurch gekennzeichnet, dass die Oxidation mindestens eine Reaktion umfasst, ausgewählt aus der Gruppe bestehend aus Bildung von Cul auf einer partikulären Kupferkomponente, Bildung von Cu20 auf einer partikulären Kupferkomponente, Bildung von Ag20 auf einer leitfähiger Komponente, Bildung von ZnS auf einer metallischen Komponente, Bildung von SnO auf einer metallischen Komponente, Bildung von Titanvier-Oxid-Verbindungen auf leitfähiger Komponente, Bildung von Titanvier-Oxid-Verbindungen mit niedervalenter Metalloxid-Beimischung.

### DETAILLIERTE ERLÄUTERUNG DER ERFINDUNG ANHAND VON AUSFÜHRUNGBEISPIELEN

In vorteilhafter Ausführungsform ist das Raumtemperatur-Verfahren zur Herstellung einer elektrotechnischen, PV-aktiven Dünnschicht-Folge, wobei elektrisch leitende und/oder halbleitende, anorganische Agglomerate in einer Dispersion flächig vorgelegt und zu einer Schicht ausgehärtet werden, dadurch gekennzeichnet, dass
- die Aushärtung bei Raumtemperatur durchgeführt wird,
- die Aushärtung durch Beaufschlagen mit mindestens einem Reagenz beschleunigt wird,
- das Verfahren in einer Druckmaschine durchgeführt wird,
- eine PV-Schichtfolge ausgebildet wird, wobei wiederum
- eine PV-aktive Schicht auf einer Trägerschicht ausgebildet wird, in dem eine fließfähige, wässrige Mischung oder Lösung vorgelegt wird,
- die Mischung oder Lösung mindestens eine anorganische Agglomeratsorte aufweist, welche ausgewählt ist aus der Gruppe bestehend aus Kieselsäure-Agglomerate, basische Kieseläure-Agglomerate, saure Kieselsäure-Agglomerate, Natrium-Wasserglas-Agglomerate, Kalium-Wasserglas-Agglomerate, Halogen-Agglomerate, lod-Agglomerate, bevorzugt eine Kombination aus Kieseläure-Agglomerat mit eingestelltem pH-Wert und Halogen-Agglomerat, umfasst,
- wobei die Mischung oder Lösung als weiteren Bestandteil mindestens eine organische, vernetzbare Komponente aufweist, deren vernetzbarer Molekülteil mindestens einen Molekülteil umfasst ausgewählt aus der Gruppe bestehend aus Lactam-Teil, Acryl-Teil, Polysaccharid-Teil, Silicium-organische Verbindung mit polymerisierbarer Seitengruppe auf Methacrylsäurebasis, Organosiloxan, Organosilylacetat, und die Mischung oder Lösung in dünner Schicht aufgedruckt, und abschließend unter begleitender Reaktion, unterstützt durch UV-Belichtung und Beaufschlagung mit Trockengas, ausgehärtet wird, wobei die PV-aktive Schicht eine anorganische Matrix mit interpenetrierendem, organischem Netzwerk ausbildet.

In weiterer, vorteilhafter Ausführungsform ist das Raumtemperatur-Verfahren zur Herstellung einer elektrotechnischen, PV-aktiven Dünnschicht-Folge wobei elektrisch leitende und/oder halbleitende, anorganische Agglomerate in einer Dispersion flächig vorgelegt und zu einer Schicht ausgehärtet werden, dadurch gekennzeichnet, dass
- in einer Druckmaschine eine PV-Schichtfolge ausgebildet wird, wobei wiederum
- eine PV-aktive Schicht auf einer Trägerschicht ausgebildet wird, in dem eine fließfähige, wässrige Mischung oder Lösung vorgelegt wird
- eine Mischung oder Lösung mit miteinander reagierenden Komponenten angesetzt, in dünner Schicht aufgedruckt, und abschließend unter weiter ablaufender Reaktion ausgehärtet wird, wobei die PV-aktive Schicht eine anorganische Matrix mit interpenetrierendem, organischem Netzwerk mit vernetzenden Binderbrücken ausbildet.

In weiterer, vorteilhafter Ausführungsform wurde eine erfindungsgemäße PV-Schichtfolge wie folgt erhalten: Bei Raumtemperatur wurde im Rahmen eines Druckprozesses auf einer Flexodruck-Maschine mit einem selbstklebenden, zweilagigen Etiketten-Papier als Träger und mit mehreren Druckstationen zunächst eine zumindest anteilig metallische Dünnschicht - vorliegend eine Kupfer-Schicht und/oder eine Silber-Schicht - auf einer reduktiv eingestellten Graphit-Kohlenstoffschicht auf dem Papier ausgebildet. Als weitere Druckpaste für die vorbenannte Maschine wurde eine elektrisch leitende und/oder halbleitende, anorganische Agglomerate in einer Dispersion aufweisende Mischung wie folgt angesetzt: Ein teiIvernetzbarer Polysaccharid-Stärke-Ether wurde als Nebenbestandteil mit Ascorbinsäure-Salzsäure-Gemisch in Dispersion auf niedrigen pH-Wert eingestellt. Der pH-Wert wurde über einen zugesetzten Farb-Indikator kontrolliert. Anschließend wurde unter ständigem Rühren in destilliertem Wasser der restliche Feststoff gelöst und mit einem Saccharid mit Dextran-Anteil versetzt, um die Viskosität einzustellen. Die saure bis stark saure Lösung wurde mit Kieselsäure als Hauptbestandteil versetzt und mit Natronlauge auf einen stark basischen pH-Wert - also bis zum Farbumschlag des Indikators - unter Rühren eingestellt. Dabei koaguliert/präzipitiert die Kieselsäure und bildet anorganische Agglomerate aus. Die stark basische Dispersion wird unter Zusatz eines basisch anlösbaren Metalls, im vorliegenden Beispiel eine geringe Menge an vollständig auflösbarem Aluminium zusammen mit einer gleichen Menge an Iod-Kaliumiodid, reduktiv eingestellt. Das Kaliumiodid löst sich begleitend unter Ausbildung eines farbigen Komplexes und erlaubt die Kontrolle der Lösungskinetik in der wässrigen Dispersion sowohl optisch als auch über die Leitfähigkeit der Mischung. Die wässrige, noch reagierende und reduktiv eingestellte Dispersion wurde als Druckpaste in eine nachfolgende Druckstation der Flexodruck-Maschine gegeben. Dadurch wird direkt nach der Bedruckung mit der Metallschicht die reduktiv eingestellte Paste aufgedruckt. Nach dem Aufdrucken der reduktiven Dispersion wurde die frische, noch feuchte Paste unter UV-Belichtung mit einer Quecksilber-Dampflampe und Beaufschlagung mit Trockenluft getrocknet. Durch die UV-Belichtung wird der Iod-Komplex zumindest anteilig wieder entfärbt, d. h. es wird elementares Iod freigesetzt und dieses reagiert während des Aushärtens begleitend mit der umgebenden Matrix und vorhandenen Chlorid-Ionen. Weiterhin kann das Iod - ebenso wie das Chlor - mit der unterseitig zuvor aufgedruckten Metallschicht reagieren. Die Erfinder gehen davon aus, dass sich so zum einen P-N-Übergänge direkt an der Metallschicht bilden und gleichzeitig entlang der anorganischen Agglomerate entsprechende Übergänge aus dem aufgelösten Metall - hier Aluminium und den freigesetzten Halogenen bilden können. Das komplette Verfahren wird in der Flexo-Druckmaschine durchgeführt. Die PV-aktive Schicht wird auf der Trägerschicht mit zumindest anteiliger Metall-Schicht ausgebildet. Variation der Menge an Salzsäure, Kaliumiodid und reduktiv aufgelöstem Metall beeinflussen Wirkungsgrad und Performance der PV-aktiven Schicht erheblich und lassen eine Optimierung der Eigenschaften zu. Die Mischung oder Lösung umfasst als weiteren Bestandteil den Polysaccharid-Teil. Die Erfinder gehen davon aus, dass dieser als Nebenbestandteil ein organisches Gerüst aufbaut, welches auch Halogenagglomerate und Interhalogenagglomerate umfasst und trägern kann. Die in dünner Schicht aufgedruckte, und abschließend unter begleitender Reaktion, unterstützt durch UV-Belichtung und Beaufschlagung mit Trockengas ausgehärtete, PV-aktive Schicht hat somit als Hauptbestandteil eine anorganische Matrix mit interpenetrierendem, organischem Netzwerk als Nebenbestandteil ausgebildet. Die PV-Schichtfolge wurde mit raumtrocknendem Leitsilber oberseitig kontaktiert; alternativ ist auch eine Bedruckung mit üblichen, selbst haftenden Elektroden und/oder mit Schichten gemäß der unterseitig gedruckten Metall-Schicht denkbar. Entscheidend ist, dass die PV-aktive Schicht nicht verdeckt wird, um eine ausreichende PV-Umwandlung von Licht Strom sicherzustellen. Die fertig kontaktierte PV-Schichtfolge wurde mit Leitungen versehen und in einem Laminator mit einer Acrylat-Thermoplasthülle eingeschweißt. Die so eingeschweißte Zelle wurde auf ihren Wirkungsgrad gemäß etablierter Si-Standards und Normen untersucht und zeigte einen Wirkungsgrad um 10 +- 4 % bei niedrigem Füllfaktor um 0,3 bis 0,4. Das erschließbare Potenzial der vorliegend hergestellten Zelle liegt mithin im Bereich zwischen 10% und 20% Wirksamkeit. In einem Klimakammer-Test in Anlehnung an IEC Norm 61215 wurde die Zelle starkem Sonnenlicht mit UV-Anteil bei 80°C und hoher Luftfeuchtigkeit ausgesetzt. Über 1000 Stunden zeigte sich keine Veränderung der Performance. Erst nachdem die Laminatverschweißung, welche nicht für den Außeneinsatz optimiert war, sich ablöste und die feuchte Atmosphäre für einige hundert Stunden direkt im Kontakt mit der Dünnschichtfolge stand, zeigte sich eine Leistungsabnahme von weniger als 6%. Die Erfinder führen die hohe Stabilität (keine anfängliche Leistungsabnahme) und die überraschend stabile Leistung selbst bei direktem Kontakt mit feuchter Atmosphäre auf das anorganische Grundgerüst zurück: Die Agglomerate haben untereinander feste Kontaktpunkte und -brücken ausgebildet. Die Matrix ist extrem stabil und kaum anfällig für Sinter- oder Korrosionsprozesse. Die vernetzte Struktur vermag zudem die hohe Flexibilität des per Printverfahren erhaltenen Produkts zu erklären: Der Papierträger kann wie ein klassisches Printprodukt gerollt, gebogen und gefaltet werden, ohne dass die aufgedruckte Dünnschichtfolge exfoliert oder abplatzt.

Ergänzende Untersuchungen zu den verwertbaren Wellenlängen ergab weiterhin: Bei der Leistungssteigerung einer Glühbirnen-Strahlungsquelle zeigte die vorliegende Zelle im Vergleich zu einer üblichen Si-PV-Zelle erheblich größere Leistungszuwächse: Wo die Si-Zelle bei erhöhter Helligkeit nur 0,5 bis 1 Prozent mehr an Strom liefert, konnte die erfindungsgemäße, gedruckte Zelle mehrere Prozent an zusätzlicher Leistung bieten. Weiterhin zeigte die erfindungsgemäße Zelle bei ausgeschalteter aber noch warmer Glühbirne eine Restleistung von um die 10% der ursprünglich verfügbaren Leerlauf-Spannung, welche mit fallender Temperatur der Glühbirne gleichsinnig zurückging. Die Erfinderführen diese überlegenen Leistungscharakteristika auf die Morphologie und eine modifizierte Bandlückenstruktur zurück: Zum einen vermag die deutlich größere Oberfläche der gedruckten Agglomerate bei stärkerem Lichteinfall mehr Photonen umzuwandeln, zum anderen machen die oberflächlich auf den Agglomeraten angeordneten, PV-aktiven und nanoskaligen Strukturen die vorliegende Zelle unempfindlicher gegenüber variiertem Einstrahlwinkel: Auch bei stark geneigtem Einstrahlwinkel kann immer noch ein erheblich größerer Teil der Leistung abgerufen werden, als dies bei etablierten, verfügbaren Si-Zellen der Fall war. Weiterhin indiziert die langwellig zum sichtbaren Spektrum angeordnete Restwirksamkeit Quantenpunkte und/oder eng beieinander liegende Energieniveaus innerhalb der Bandlücke, welche das Umwandeln langwelliger Photonen erlauben. Die Erfinder gehen davon aus, dass die reaktiv ausgebildeten, nanoskaligen Strukturen hier die Bandlücke modifizieren. Das vermag sinnvoll zu erklären, warum die vorbeschriebene Zelle auch bei scheinbarer Dunkelheit eine nutzbare, konstante Restleistung mittels einer warmen Glühbirne bereitstellen konnte.

### INDUSTRIELLE ANWENDBARKEIT

Nachteilig ist bei den klassischen, gedruckten PV-Schichtzellen, dass diese in der Herstellung häufig teure Vakuum-Präparationen und thermische Temper- oder Sinterschritte vorsehen, wobei die dünnen, dotierten Vakuum-Schichten sehr korrosions- und verschmutzungsanfällig sind. Aufgabe war es daher, die Nachteile zu überwinden und ein geeignetes Verfahren sowie eine passende PV-Schichtfolge bereitzustellen. Die Lösung erfolgt durch ein Raumtemperatur-Verfahren, bei dem wässrige Dispersionen auf einen Träger aufgedruckt und unter begleitender Reaktion ausgehärtet werden. Die begleitende Reaktion bildet Gradienten und auch nanoskalige Strukturen an den Schichtgrenzen aus, welche eine PV-aktive Schicht mit üblichem Leistungsvermögen und hoher Stabilität erzeugen. Um die 10% Wirkungsgrad sind stabil und ohne anfänglichen Leistungsverlust im Klimakammertest zugänglich und auf 20 Jahre Testzeit konstant mit geringer Schwankung verfügbar. Das Verfahren ist frei von Temper- oder Sinterschritten, erlaubt die Verwendung technisch reiner, günstiger Ausgangsstoffe und macht die PV-Schichtfolge als fertige, hoch flexible Zelle für einen Bruchteil des üblichen Invests einer Produktion oder eines Vertriebs zugänglich. Eine Produktion von PV-Schichtfolgen kann hier erstmals komplett analog zur Fertigung eines Printprodukts erfolgen. Mithin kann die Erfindung eine extrem vielseitige Anwendbarkeit sowohl Herstellungs- als auch Verwendungsseitig in all den Bereichen bieten, in denen etablierte PV-Dünnschichten bisher als zu teuer oder zu instabil abgelehnt wurden.

## Patentansprüche

1. Raumtemperatur-Verfahren zur Herstellung einer PV-Schichtfolge, bei dem
- ohne Temper- oder Sinterschritte,
- wässrige Dispersionen auf einen Träger aufgedruckt und unter begleitender Reaktion ausgehärtet werden,
- die PV-Schichtfolge als Dünnschichtfolge zumindest inklusive Kontaktelektroden bei Raumtemperatur in kontinuierlichem Druckprozess gedruckt wird,
- mindestens eine wässrige Lösung und / oder Mischung umfassend elektrisch leitende und/oder halbleitende, anorganische Agglomerate aufgedruckt und unter begleitender, chemischer Reaktion zu einer PV-aktiven Schicht ausgehärtet wird,
- während der begleitenden Reaktion nanoskalige Strukturen umfassend mindestens eine Struktur ausgewählt aus der Gruppe bestehend aus Ketten, Netzen, Netz-Röhren, Leerstellen, Poren in der PV-Schichtfolge ausgebildet werden,
- die Aushärtung durch Beaufschlagen mit mindestens einem Reagenz beschleunigt wird,
- elektrisch leitende und/oder halbleitende, anorganische Agglomerate in einer Dispersion flächig vorgelegt und zu einer Schicht ausgehärtet werden, wobei wiederum
- eine PV-aktive Schicht auf einer Trägerschicht ausgebildet wird, in dem eine fließfähige, wässrige Dispersion vorgelegt wird,
- die Dispersion mit miteinander reagierenden Komponenten angesetzt und in dünner Schicht auf eine leitfähige Komponente aufgedruckt wird,
- die begleitende Reaktion der aufgedruckten Schicht eine oberflächliche Oxidation einer metallischen Komponente umfasst,
- abschließend unter weiter ablaufender Reaktion ausgehärtet wird, wobei die PV-aktive Schicht eine anorganische Matrix mit interpenetrierendem, organischem Netzwerk mit vernetzenden Binderbrücken ausbildet und die organische Matrix mindestens eine vernetzte Komponente aufweist, welche ausgewählt ist aus der Gruppe bestehend aus Polyamid-Komponente, Poly-Acrylat-Komponente, Polyol-Komponente, Polyester-Komponente, Poly-Hexosen-Komponente, Poly-Aminosäuren-Komponente, quellfähige Poly-Hexosen-Komponente, Rotalgen-Extrakt, AgarAgar, Maisstärke, Kartoffelstärke, Stärke, Carrageen, Tragant, quellfähiges Polysaccharid, Gummi Arabicum, Alginate, Pektin, quellfähiges Polypeptid, Gelatine, Carboxymethylcellulose, Hydroxyethylcellulose, Polyacryle, Polycarbonsäuren, Polyether, Polyamide, Polyimide, Silicium-organische Verbindung mit polymerisierbarer Seitengruppe auf Methacrylsäurebasis, Organosiloxan.

## Claims

1. Method for producing a PV layer sequence at room temperature, in which
- without annealing or sintering steps,
- aqueous dispersions are printed onto a carrier and cured in an accompanying reaction,
- the PV layer sequence is printed as a thin layer sequence at least including contact electrodes at room temperature in a continuous printing process,
- at least one aqueous solution and/or mixture comprising electrically conductive and/or semiconductive, inorganic agglomerates is printed and cured to form a PV active layer in an accompanying chemical reaction,
- during the accompanying reaction, nanoscale structures comprising at least one structure selected from the group consisting of chains, nets, net tubes, spaces, pores are formed in the PV layer sequence,
- the curing is accelerated by exposure to at least one reagent,
- electrically conductive and/or semiconductive, inorganic agglomerates are provided planarly in a dispersion and cured to form a layer, wherein, however,
- a PV active layer is formed on a carrier layer by a flowable, aqueous dispersion being provided,
- the dispersion is prepared with components that react with each other and printed in a thin layer onto a conductive component,
- the accompanying reaction of the printed layer involves a superficial oxidation of a metal component,
- is finally cured while the reaction continues, wherein the PV active layer forms an inorganic matrix with an interpenetrating, organic network having crosslinking binder bridges and the organic matrix has at least one cross-linked component which is selected from the group consisting of polyamide component, polyacrylate component, polyol component, polyester component, polyhexose component, polyamino acid component, swellable polyhexose component, red algae extract, agar agar, corn starch, potato starch, starch, carrageenan, tragacanth, swellable polysaccharide, gum arabic, alginates, pectin, swellable polypeptide, gelatin, carboxymethylcellulose, hydroxyethylcellulose, polyacrylics, polycarboxylic acids, polyethers, polyamides, polyimides, silicon-organic compound with polymerizable side group based on methacrylic acid, organosiloxane.

## Revendications

1. Procédé à température ambiante pour la fabrication d'une séquence de couches photovoltaïques, dans lequel
- sans étape de recuit ou de frittage,
- des dispersions aqueuses sont imprimées sur un support et durcies avec une réaction concomitante,
- la séquence de couches photovoltaïques est imprimée en tant que séquence de couches minces, au moins en comportant des électrodes de contact, à température ambiante lors d'un processus d'impression continu,
- au moins une solution et/ou un mélange aqueux comprenant des agglomérats inorganiques électriquement conducteurs et/ou semi-conducteurs sont imprimés et durcis avec une réaction chimique concomitante pour former une couche photovoltaïque active,
- pendant la réaction concomitante, des structures nanométriques comprenant au moins une structure choisie dans le groupe constitué de chaînes, mailles, tubes maillés, espaces vides, pores sont formées dans la séquence de couches photovoltaïques,
- le durcissement est accéléré par l'exposition à au moins un réactif,
- des agglomérats inorganiques électriquement conducteurs et/ou semi-conducteurs sont déposés à plat dans une dispersion et durcis pour former une couche, dans lequel ensuite
- une couche photovoltaïque active est formée sur une couche de support, dans laquelle une dispersion aqueuse fluide est déposée,
- la dispersion est préparée avec des composants qui réagissent entre eux et est imprimée en couche mince sur un composant conducteur,
- la réaction concomitante de la couche imprimée comprend une oxydation superficielle d'un composant métallique,
- est finalement durcie avec une réaction continue supplémentaire, dans lequel la couche photovoltaïque active forme une matrice inorganique comportant un réseau organique interpénétrant comportant des ponts de jonction réticulants et la matrice organique présente au moins un composant réticulé qui est choisi dans le groupe constitué de composant polyamide, composant polyacrylate, composant polyol, composant polyester, composant polyhexose, composant polyaminoacide, composant polyhexose gonflant, extrait d'algue rouge, agar-agar, amidon de maïs, amidon de pomme de terre, amidon, carraghénane, gomme adragante, polysaccharide gonflant, gomme arabique, alginate, pectine, polypeptide gonflant, gélatine, carboxyméthylcellulose, hydroxyéthylcellulose, polyacryliques, acides polycarboxyliques, polyéthers, polyamides, polyimides, composé organo-silicique à groupe latéral polymérisable à base d'acide méthacrylique, organosiloxane.
